# EUROPEAN PATENT SPECIFICATION

(11) **EP 2 149 540 B1**
(45) Date of publication and mention of the grant of the patent: **14.04.2021**
(21) Application number: 09009862.5
(22) Date of filing: 30.07.2009
(51) Int. Cl.: C03C 17/34, C03C 17/42, C23C 14/06, C23C 14/10, C23C 14/12, G04B 39/00

(54) **Transparent member, timepiece, and method of manufacturing a transparent member**
Transparentes Element, Uhr und Verfahren zur Herstellung eines transparenten Elements
Élément transparent, montre, et procédé de fabrication d'un élément transparent

(30) Priority: 31.07.2008 JP 2008198453
(43) Date of publication of application: 03.02.2010
(73) Proprietor: Seiko Epson Corporation, Shinjuku-ku Tokyo (JP)
(72) Inventor: Suzuki, Katsumi, Suwa-shi Nagano 392-8502 (JP); Suzuki, Keiichi, Suwa-shi Nagano 392-8502 (JP); Seki, Hiroyuki, Suwa-shi Nagano 392-8502 (JP)
(74) Representative: Hoffmann Eitle

(56) References cited:
- EP-A- 1 148 037
- WO-A-01/37006
- WO-A-03/074440
- FR-A- 2 898 295
- JP-A- 2004 271 480
- US-A1- 2004 253 369

## Description

### BACKGROUND

### 1. Field of Invention

The present invention relates to a transparent member which can be used as the crystal of a timepiece, to a timepiece using this transparent member, and to a method of manufacturing this transparent member.

### 2. Description of Related Art

An antireflection coating is commonly formed on the transparent member known as the crystal in order to improve the legibility of the time and other information displayed on a timepiece . The antireflection coating is generally formed by laminating several to several ten layers of inorganic materials with different refractive indices. When high hardness and scratch resistance are needed on the surface of the crystal, a layer of SiO₂ having high optical transparency, a low refractive index, and relatively high hardness is often formed as the outside surface layer of the antireflection coating. Japanese Unexamined Patent Appl. Pub. JP-A-2004-271480, for example, teaches technology for forming an antireflection coating having alternating layers of SiO₂ and Si₃N₄ on the surface of timepiece crystal with SiO₂ used for the very top and very bottom layers . Japanese Unexamined Patent Appl. Pub. JP-A-2006-275526 also teaches a timepiece crystal having a silicon nitride film formed on the surface of the timepiece crystal with a top outside layer of silicon oxide (SiO₂)

Additionally, FR 2 898 295 A discloses glass substrates with antireflective coating comprising alternating layers of SiO₂ and Si₃N₄. Fluorosilane outermost layers are known from US 2004/0253369 A1.

A problem with a wristwatch according to the related art having an antireflection coating formed by alternately laminating SiO₂ layers and Si₃N₄ layers is that the surface of the crystal is easily scratched deeply during everyday use. However, the reason for this has not been particularly clear, and how a lamination of different hardness films such as SiO₂ layers and Si₃N₄ layers affects the hardness and scratch resistance of the crystal surface was unknown. As a result, optical simulations of antireflection coatings on timepiece crystals have been conducted without considering the thickness ratio of the SiO₂ layer and Si₃N₄ layer.

### SUMMARY

An object of the present invention is to provide a timepiece comprising a transparent member that has an antireflection function, sufficiently high hardness, and scratch resistance, and a method of manufacturing a transparent member.

As a result of researching the scratch resistance of antireflection coatings, we determined that an average thickness of approximately 150 nm from the outermost surface layer greatly affects scratch resistance. More specifically, we repeatedly examined the hardness, scratch resistance, and optical characteristics while variously changing the thickness of the relatively soft SiO₂ layer and the hard Si₃N₄ layer. As a result, we learned that scratch resistance improves as hardness rises to a depth of 150 nm from the outside surface of the antireflection coating, but an increase in hardness at depths greater than 150 nm has little effect on scratch resistance. We also demonstrated that a condition for balancing high scratch resistance and low reflectivity is when the ratio of the Si₃N₄ layer is 34 to 50 vol% in the region from the outside surface of the antireflection coating to a depth of 150 nm.

A first aspect of the invention is a timepiece comprising a a transparent member having a transparent substrate, and an antireflection coating that has a high index of refraction layer made of silicon nitride and a low index of refraction layer made of silicon oxide alternately laminated on at least a part of a surface of the substrate. The content of silicon nitride in the region to a depth of 150 nm from the outside surface of the antireflection coating is 34 - 50 vol%.

Examples of such a transparent member include a cover member for a timepiece, a cover member for a measuring instrument, eyeglass lenses, and other members that are hard and transparent. The substrate of the transparent member may be made of sapphire glass, quartz glass, or soda glass, for example.

This aspect of the invention can form an antireflection coating with extremely high hardness on a substrate because a specific antireflection coating is formed on a substrate so that the silicon nitride content in the region to a depth of 150 nm from the outside surface of the antireflection coating is greater than or equal to 30 vol%.

If the siliconnitride content in the region to this specified depth is less than 34 vol%, the scratch resistance of the antireflection coating is insufficient and its utility on a crystal for a timepiece will be poor. In addition, because the silicon nitride content in the region to a depthof 150 nm from the outside surface of the antireflection coating is less than or equal to 50 vol%, the antireflection effect is also outstanding. If the silicon nitride content in the region to this specified depth exceeds 50 vol%, the antireflection effect is poor and its utility on a crystal for a timepiece will be poor.

The silicon nitride content in the region to a depth of 150 nm from the outside surface of the antireflection coating is preferably in the range 40 - 50 vol% . This preferred embodiment results in a further improvement of the scratch resistance while maintaining the antireflection effect.

The film thickness of the outside layer that is made of silicon oxide is preferably 70 - 110 nm, and further preferably 75 - 105 nm. The film thickness of the silicon nitride layer that is adjacent to the outside surface layer is preferably 50 - 115 nm, and is yet further preferably 55 - 110 nm. If these film thicknesses deviate from these ranges, the reflectivity of the antireflection coating tends to increase.

In a transparent member according to another aspect of the invention the surface hardness of the transparent member is greater than or equal to 24000 N/mm². The test load used here is 1.225 mN.

Because the surface hardness of the transparent member is greater than or equal to 24000 N/mm² in this aspect of the invention, it is excellent for use as a timepiece crystal or cover member. Even better scratch resistance can be achieved if the surface hardness is greater than or equal to 30000 N/mm².

According to the invention a stain resistant coating made of a fluorinated organosilicon compound is formed on the antireflection coating.

By forming a stain resistant coating made of a fluorinated organosilicon compound on the antireflection coating, several advantages can be achieved. In addition to exhibiting a water and oil repellency effect, this stain resistant coating also has extremely outstanding surface slipperiness because it is made of a fluorinated organosilicon compound. If the transparent member is subject to external impact, the surface slipperiness of the stain resistant coating can soften the impact, thereby resulting in excellent abrasion resistance. Due to this effect, the stain resistant coating effectively prevents separation of the antireflection coating. Note that the fluorinated organosilicon compound may be any compound that is water repellant, oil repellant, and stain resistant.

In a transparent member according to this preferred aspect of the invention the fluorinated organosilicon compound is preferably an alkoxysilane compound.

By using an alkoxysilane compound as the fluorinated organosilicon compound, water repellency and oil repellency are high and outstanding stain resistance is exhibited.

An organosilicon compound containing a perfluoro group and an alkoxysilyl group such as a methoxysilyl group or triethoxysilyl group is preferably used as the alkoxysilane compound.

Preferably, the fluorinated organosilicon compound is a perfluoroether compound described in at least one of formula (1) and formula (2) shown below. 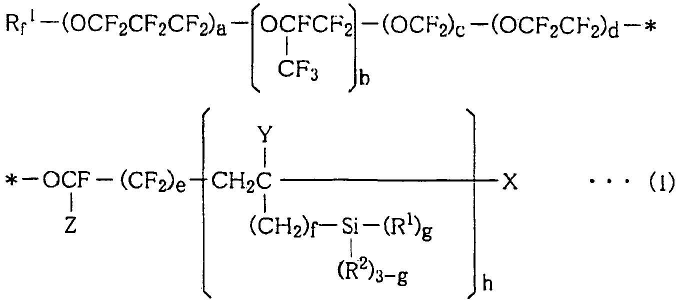 where
R_{f}¹ denotes a perflouroalkyl group;
X denotes boron, iodine, or hydrogen;
Y denotes hydrogen or a lower alkyl group;
Z denotes fluorine or a trifluoromethyl group;
R¹ denotes a hydrolyzable group;
R² denotes hydrogen or an inert monovalent hydrocarbon group;
a, b, c, d, and e are 0 or an integer greater than or equal to 1, a+b+c+d+e is at least greater than or equal to 1, and the order of the repeating units denoted by a, b, c, d, and e is not limited to the order shown in the formula;
f is 0, 1, or 2;
g is 1, 2, or 3; and
h is an integer of 1 or more. 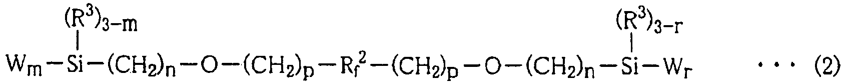
where
R_{f}² denotes a bivalent group that has a straight chain perfluoropolyalkylenether structure with no branches and includes a [- (CₖF₂ₖ)O-] unit where the k in [- (CₖF_{zk}) O-] is an integer of 1 - 6;
R³ is a monovalent hydrocarbon group with 1 - 8 carbon atoms;
W denotes a hydrolyzable group or a halogen atom;
p is 0, 1, or 2;
n is an integer of 1 - 5; and
m and r are 2 or 3.

By depositing a fluorinated organosilicon compound described in at least one of formulae (1) and (2) on the antireflection coating, a transparent member with outstanding stain resistance can be produced. These fluorinated organosilicon compounds may be used alone or mixed together.

In a transparent member according to this aspect of the invention, the thickness of the stain resistant coating is preferably 0.001 - 0.05 µm, further preferably 0.001 - 0.03 µm, and yet further preferably 0.001 - 0.02 µm.

If the thickness of the stain resistant coating is less than 0.001 µm, water and oil repellency may not be sufficient, and it tends to be difficult to achieve outstanding abrasion resistance and chemical resistance. If the thickness of the stain resistant coating is less than or equal to 0.05 µm, the the surface hardness of the transparent member is unlikely to be decreased. The transparency of the substrate is alsonot impairedbecause the stain resistant coatingproduces little surface diffusion of light.

The transparent member according to the invention is a cover member, and the antireflection coating is formed on at least a part on the outside side from among a group including parts on the inside side and parts on the outside side of the cover member.

Because this aspect of the invention can prevent reflection of light incident from the outside of the cover member on the incidence side, a better antireflection effect is achieved than when the antireflection coating is formed on a part on the exit side that is on the inside side of the cover member.

The invention is a timepiece that has the transparent member described above with the transparent member disposed to a case that houses a timepiece movement.

By using the transparent member described above, a timepiece according to this aspect of the invention has the benefit of the same operation and effect. The transparent member may, for example, be disposed to the case as a crystal or back cover.

Another aspect of the invention is a method of manufacturing the transparent member described above, including a sputtering step of forming the high index of refraction layer and low index of refraction layer rendering the antireflection coating by sputtering.

By forming the antireflection coating by a sputteringmethod, this aspect of the invention can not only improve the hardness of the entire antireflection coating compared with forming the high index of refraction layer and low index of refraction layer by simple evaporation, it can also achieve outstanding adhesion between the antireflection coating and the substrate and outstanding interlayer adhesion between the layers of the antireflection coating. As a result, this also contributes to improving abrasion resistance.

The method of manufacturing of transparent member according to another aspect of the invention preferably also has a heating step whereby sputtering is done while heating the substrate to 100°C or higher in order to further improve hardness and adhesion.

Yet further preferably, a bias sputtering step of reverse sputtering the substrate is executed before forming the antireflection coating by sputtering because the substrate surface can be cleaned and adhesion between the substrate and antireflection coating can be further improved.

The invention thus provides a transparent member with both an antireflection function and scratch resistance, a timepiece having this transparent member, and a method of manufacturing the transparent member.

Other objects and attainments together with a fuller understanding of the invention will become apparent and appreciated by referring to the following description and claims taken in conjunction with the accompanying drawings.

### BRIEF DESCRIPTION OF THE DRAWINGS

FIG. 1 is a schematic section view of a crystal according to a first embodiment of the invention.
FIG. 2 is a schematic section view of a crystal according to a second embodiment of the invention.

### DESCRIPTION OF PREFERRED EMBODIMENTS

Preferred embodiments of the present invention are described below with reference to the accompanying figures.

### * First embodiment (not according to the present invention)

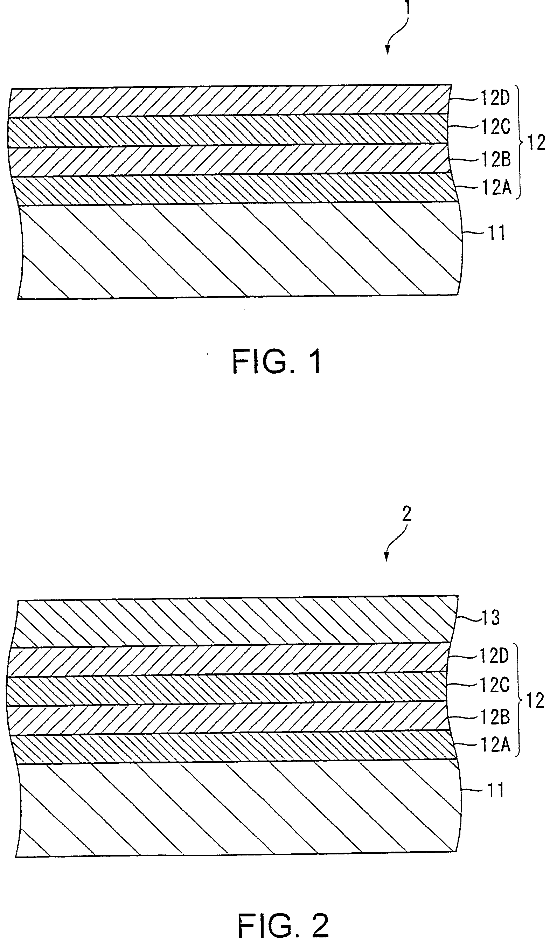

A transparent member according to a first embodiment of the invention is a timepiece crystal (also referred to as simply "crystal") , and FIG. 1 is a section view of a crystal 1 according to this embodiment of the invention. The crystal 1 has a transparent substrate 11 and an antireflection coating 12 formed thereon.

### * Material of the substrate 11

The material used for the substrate 11 is an inorganic oxide material such as sapphire glass, quartz glass, or soda glass. Sapphire glass is particularlypreferable as the material for a timepiece crystal due to its hardness and transparency.

### * Configuration of the antireflection coating 12

The antireflection coating 12 is a multilayer film that is formed on the substrate 11 by alternately laminating inorganic thin films with different indices of refraction. In the crystal 1 shown in FIG. 1, the antireflection coating 12 has four layers, a high index of refraction layer 12A, a low index of refraction layer 12B, a high index of refraction layer 12C, a low index of refraction layer 12D.

The high index of refraction layers 12A and 12C are made of silicon nitride (SiNx) , and the low index of refraction layers 12B and 12D are made of silicon oxide (SiO₂) . The silicon nitride content in the region to a depth of 150 nm from the outside surface of the antireflection coating 12 is 30 - 50 vol%.

Note that the antireflection coating 12 is not limited to four layers, and may have five or more layers. More layers is preferable from the perspective of improving the antireflection effect. However, too many layers can cause production problems, and the number of layers is therefore preferably nine or less.

Furthermore, the film thickness of the outside layer of silicon oxide (low index of refraction layer 12D) is preferably 70 - 110 nm, and yet further preferably 75 - 105 nm. In addition, the film thickness of the silicon nitride layer (high index of refraction layer 12C) adjacent to the outside surface layer is preferably 50 - 115 nm, and yet further preferably 55 - 110 nm. If these film thicknesses deviate from these ranges, the reflectivity of the antireflection coating tends to increase.

The surface hardness of the crystal 1 shown in FIG. 1 is 24000 N/mm² or greater when measured according to ISO 14577 using a nanoindenter (1.225 mN test load).

### * Forming the antireflection coating 12

A sputtering method can be advantageously used to form the antireflection coating described above on the surface of the substrate 11. Vacuum deposition can also be used, and vacuum evaporation can be suitably used in combination with other techniques such as ion beam assisted evaporation. However, sputtering is preferably used to produce an antireflection coating with superior hardness . Sputtering and vacuum deposition can use methods commonly used for inorganic film formation.

Furthermore, when sputtering is used, there is preferably a heating process that heats the substrate 11 to 100°C or more in order to achieve the hardness and adhesion described above.

Yet further, if a bias sputtering process to remove contaminants from the surface is applied to the substrate 11 before forming the antireflection coating 12 by sputtering, the surface of the substrate 11 can be cleaned and adhesion between the substrate 11 and antireflection coating 12 can be improved.

The effect of the embodiment described above is described next.

The crystal 1 is composed of a substrate 11 and a antireflection coating 12. The antireflection coating 12 is rendered by alternately laminating high index of refraction layers 12A and 12C and low index of refraction layers 12B and 12D, and the silicon nitride content in the region to a depth of 150 nm from the outside surface of the antireflection coating 12 is 30 - 50 vol%.

The surface of the antireflection coating 12 is therefore a layer with extremely high hardness. If the silicon nitride content in the region to this specified depth is less than 30 vol%, the scratch resistance of the antireflection coating is insufficient and its utility on a crystal for a timepiece will be poor. In addition, because the silicon nitride content in the region from the outside surface of the antireflection coating 12 to a depth of 150 nm is less than or equal to 50 vol%, the antireflection effect is also outstanding. If the silicon nitride content in the region to this specified depth exceeds 50 vol%, the antireflection effect is poor and its utility on a crystal for a timepiece will be poor. However, if the silicon nitride content in the region from the outside surface of the antireflection coating 12 to a depth of 150 nm is greater than or equal to 40 vol%, the scratch resistance can be further improved while maintaining the antireflection effect.

Because the surface hardness of the crystal 1 is greater than or equal to 24000 N/mm², sufficient scratch resistance can be achieved and abrasion resistance sufficient for use in wristwatches and other portable devices can be achieved. Even better scratch resistance can be achieved if the surface hardness is greater than or equal to 30000 N/mm².

### * Second embodiment

A stain resistant coating can also be formed on the antireflection coating 12 described above. FIG. 2 shows a crystal 2 that additionally has a stain resistant coating 13 formed over the antireflection coating 12 described above. This stain resistant coating 13 is described below.

### * Composition of the stain resistant coating 13

The stain resistant coating 13 is rendered from compounds known as water repellants and oil repellants. These compounds are preferably fluorinated organosilicon compounds such as alkoxysilane.

Examples of these compounds include the following: CF₃ (CF₂)₂C₂H₄Si(OCH₃)₃, CF₃(CF₂)₄C₂H₄Si(OCH₃)₃, CF₃(CF₂)₆C₂H₄Si(OCH₃)₃, CF₃(CF₂)₈C₂H₄Si(OCH₃)₃, CF₃(CF₂)₁₀C₂H₄Si(OCH₃)₃, CF₃(CF₂)₁₂C₂H₄Si(OCH₃)₃, CF₃(CF₂)₁₄C₂H₄Si(OCH₃)₃, CF₃(CF₂)₁₆C₂H₄Si(OCH₃)₃, CF₃(CF₂)₁₈C₂H₄Si(OCH₃)₃, CF₃(CF₂)₆C₂H₄Si(OC₂H₅)₃, CF₃(CF₂)ₑC₂H₄Si(OC₂H₅)₃, CF₃(CF₂)₆C₂H₄SiCl₃, CF₃(CF₂)₆C₂H₄SiCl₃, CF₃(CF₂)₆C₃H₆Si(OCH₃)₃, CF₃(CF₂)₈C₃H₆Si(OCH₃)₃, CF₃(CF₂)₆C₃H₆Si(OC₂H₅)₃, CF₃(CF₂)₈C₃H₆Si(OC₂H₅)₃, CF₃(CF₂)₆C₃H₆SiCl₃, CF₃(CF₂)ₑC₃H₆SiCl₃, CF₃(CF₂)₆C₄HₑSi(OCH₃)₃, CF₃(CF₂)₈C₄H₈Si(OCH₃)₃, CF₃(CF₂)₆C₄H₈Si(OC₂H₅)₃, CF₃(CF₂)₈C₄H₈Si(OC₂H₅)₃, CF₃(CF₂)₆C₂H₄Si(CH₃)(OCH₃)₂, CF₃(CF₂)₈C₂H₄Si(CH₃)(OCH₃)₂, CF₃(CF₂)₆C₂H₄Si(CH₃)Cl₂, CF₃(CF₂)₈C₂H₄Si(CH₃)Cl₂, CF₃(CF₂)₆C₂H₄Si(C₂H₅)(OC₂H₅)₂, and CF₃(CF₂)₈C₂H₄Si(C₂H₅)(OC₂H₅)₂.

A compound containing an amino group is preferable as the fluorinated organosilicon compound. Examples include the following: C₉F₁₉CONH(CH₂)₃Si(OC₂H₅)₃, C₉F₁₉CONH(CH₂)₃SiCl₃, C₉F₁₉CONH(CH₂)₃Si(CH₃)Cl₂, C₉F₁₉CONH(CH₂)NH(CH₂)Si(OC₂H₅)₃, C₉F₁₉CONH(CH₂)₅CONH(CH₂)Si(OC₂H₅)₃, C₈F₁₇SO₂NH(CH₂)₅CONH(CH₂)Si(OC₂Hₛ)₃, C₃F₇O(CF(CF₃)CF₂O)₂-CF(CF₃)-CONH(CH₂)Si(OC₂H₅)₃, and C₃F₇O(CF(CF₃)CF₂O)m'-CF(CF₃)-CONH(CH₂)Si(OCH₃)₃ (where m' is an integer greater than or equal to 1).

Compounds such as the following are also desirable as the fluorinated organosilicon compound: Rf'(CH₂)₂SiCl₃, Rf'(CH₂)₂Si(CH₃)Cl₂, (Rf'CH₂CH₂)₂SiCl₂, Rf'(CH₂)₂Si(OCH₃)₃, Rf'CONH(CH₂)₃Si(OC₂H₅)₃, Rf'CONH(CH₂)₂NH(CH₂)₃Si(OC₂H₅)₃, Rf'SO₂N(CH₃)(CH₂)₂CONH(CH₂)₃Si(OC₂H₅)₃, Rf'(CH₂)₂OCO(CH₂)₂S(CH₂)₃Si(OCH₃)₃, Rf'(CH₂)₂OCONH(CH₂)₂Si(OC₂H₅)₃, Rf'COO-Cy(OH)-(CH₂)₂Si(OCH₃)₃, Rf'(CH₂)₂NH(CH₂)₂Si(OCH₃)₃, and Rf'(CH₂)₂NH(CH₂)₂NH(CH₂)₂Si(OCH₂CH₂OCH₃)₃. Note that in the foregoing formulae Cy denotes a cyclohexane residue, and Rf' is a polyfluoroalkyl group with 4 - 16 carbons.

The fluorinated organosilicon compound used in the invention is preferably a compound described by either one of the following formulas (1) and (2). 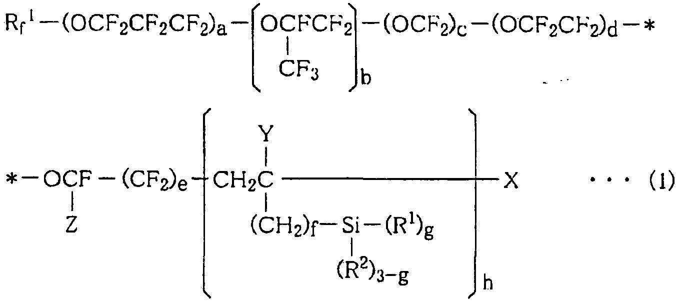 where
R_{f}¹ denotes a perflouroalkyl group;
X denotes boron, iodine, or hydrogen;
Y denotes oxygen or a lower alkyl group;
Z denotes fluorine or a trifluoromethyl group;
R¹ denotes a hydrolyzable group;
R² denotes hydrogen or an inert monovalent hydrocarbon group;
a, b, c, d, and e are 0 or an integer greater than or equal to 1, a+b+c+d+e is at least greater than or equal to 1, and the order of the repeating units denoted by a, b, c, d, and e is not limited to the order shown in the formula;
f is 0, 1, or 2;
g is 1, 2, or 3; and
h is an integer of 1 or more. 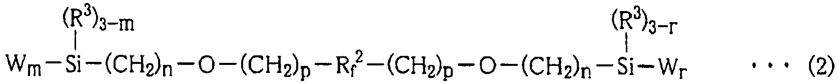
where
R_{f}² denotes a bivalent group that has a straight chain perfluoropolyalkylenether structure with no branches and includes a [-(CₖF₂ₖ)O-] unit where the k in [-(CₖF₂ₖ)O-] is an integer of 1 - 6;
R³ is a monovalent hydrocarbon group with 1 - 8 carbon atoms;
W denotes a hydrolyzable group or a halogen atom;
p is 0, 1, or 2;
n is an integer of 1 - 5; and
m and r are 2 or 3.

By forming a fluorinatedorganosilicon compoundas described above on the surface of the antireflection coating 12 as a stain resistant coating 13, a crystal with an outstanding water repellency and oil repellency effect and outstanding abrasion resistance can be achieved. These fluorinated organosilicon compounds can be used alone or in combination. Using a mixture of compounds described by the foregoing formulae (1) and (2) is particularly desirable because the durability of the stain resistant coating is improved.

Specific examples of these fluorinated organosilicon compounds include TSL8233 and TSL8257 manufactured by GE Toshiba Silicone K.K. , Optool DSX from Daikin Industries Ltd., and KY130 and KP801 from Shin-Etsu Chemical Co.., Ltd.

### * Forming the stain resistant coating 13

A dry method or a wet method may be used to form the stain resistant coating 13. Both methods are described below.

### * Dry method

A vacuum evaporation method that vaporizes and deposits the fluorinated organosilicon compound in a vacuum chamber onto the surface of the substrate 11 (antireflection coating 12) can be used as a dry method. The vacuum evaporation systems described in Japanese Unexamined Patent Appl. Pub. JP-A-H06-340966 or Japanese Unexamined Patent Appl. Pub. JP-A-2005-301208 can be advantageously used. More specifically, the stain resistant coating 13 can be formed as described below.

A processing solution acquired by dissolving and diluting a fluorinated organosilicon compound in a suitable fluorochemical solvent is added to a fibrous or porous medium which is then heated in a vacuum chamber under a pressure of 1 - 0.0001 Pa and thereby deposited onto the antireflection coating 12 of the crystal 1 placed in the vacuum chamber to form the stain resistant coating 13. The fluorochemical solvent that is used can be the same as the solvents described in the wetmethodbelow. Note that because the amount of solvent used is minimal, there is substantially no environmental impact.

The medium used in this process is preferably a conductive fiber or porous sintered metal from the perspective of thermal conductivity and heating efficiency, and the material is preferably copper or stainless steel. In order to achieve a desirable vaporization rate, the sintered metal or other porous material preferably has a pore size of 40 - 200 µm, and yet further preferably 80 - 120 µm.

The temperature when heating the fluorinated organosilicon compound disposed to the medium to form the stain resistant coating 13 differs according to the pressure inside the vacuum chamber, but is preferably set within a range not exceeding the breakdown temperature of the organosilicon compound.

The pressure when forming the stain resistant coating 13 is preferably 0.5 - 0.005 Pa, and yet further preferably 0.1 - 0.001 Pa. If the pressure when forming the stain resistant coating 13 is greater than 1 Pa, the average free state of the vapor molecules is short and the stain resistant coating 13 formation rate is slow. However, if the pressure is below 0.0001 Pa, the stain resistant coating 13 formation rate is faster but the time required to achieve the vacuum state is too long and such pressures are therefore undesirable.

The stain resistant coating 13 formation rate (deposition rate) is preferably 0.05 - 5.0 Å/s, and further preferably 0.1 - 2.0 Å/s. If less than 0.05 Å/s, productivity is low and the manufacturing cost is too high. However, if greater than 2.0 Å/s, the layer thickness distribution of the stain resistant coating 13 is uneven and surface slipperiness deteriorates. Note that the stain resistant coating 13 formation rate can be controlled by adjusting the pressure of the vacuum chamber and the heating temperature.

Note that with vacuum evaporation methods the fluorinated organosilicon compound can be used at a high concentration or without a diluting solvent.

### * Wet methods

### Processing agent preparation

In order to form the stain resistant coating 13 on the substrate 11 (antireflection coating 12) using a wet method, a method that dissolves any fluorinated organosilicon compound described above in an organic solvent to a specific concentration, and then coats the resulting solution on the surface of the substrate 11 can be used. The organic solvent is preferably an organic compound of four or more carbons that has a perfluoro group having outstanding solubility with a fluorinated organosilicon compound. Examples include perfluorohexane, perfluorocyclobutane, perfluorooctane, perfluorodecane, perfluoromethylcyclohexane, perfluoro-1, 3-dimethylcyclohexane, perfluoro-4-methoxybutane, perfluoro-4-ethoxybutane and metaxylene hexafluoride. Furthermore, perfluoroether oil and chlorotrifluoroethylene oligomer oil can be used. Other than these, chlorofluorocarbon 225 (a mixture of CF₃CF₂CHCl₂ and CClF₂CF₂CHClF) can be cited. Each of these organic solvents can be used alone or combinations of two or more kinds may be used.

The concentration when diluted with an organic solvent is preferably in the range of 0.03 - 1% by weight. Forming a stain resistant coating 13 with sufficient thickness is difficult when the concentration is less than 0.03 wt% and too low, and it may not be possible to obtain sufficient water and oil repellency, or sufficient slipperiness. If the concentration is greater than 1 wt% and too high, the stain resistant coating 13 may be too thick and a rinse process may be required to remove coating irregularities after coating.

### Coating process

Coatingmethods that maybe used include dipping (immersion) , spin coating, spraying, flowing, doctor blading, roll coating, gravure coating, curtain coating, and brushing. The thickness of the stain resistant coating 13 is not specifically limited, but is preferably 0.001 - 0.05 µm, further preferably 0.001 - 0.03 µm, and yet further preferably 0.001 - 0.02 µm.

If the thickness of the stain resistant coating 13 is less than 0.001 µm, water and oil repellency may not be sufficient and there may be a loss of slipperiness, and the abrasion resistance and chemical resistance may therefore be reduced. However, if the thickness of the stain resistant coating exceeds 0.05 µm, the surface hardness of the crystal 2 may be reduced and the transparency of the substrate 11 may be impaired because of surface diffusion of light by the stain resistant coating 13.

If a dipping method is used, the substrate 11 is immersed in the processing solution adjusted to the specified concentration using an organic solvent as described above, and after waiting a specified time the substrate 11 is lifted out of the solution at a constant rate. The immersion time is preferably from 0.5 minute to approximately 3 minutes.

The specified water and oil repellency or slipperiness may not be obtained if the immersion time is less than 0.5 minute because adsorption of the fluorinated organosilicon compound in the surface of the substrate 11 is not sufficient. Conversely, the cycle time increases undesirably if the immersion time is greater than 3 minutes .

The lift-out speed is preferably 100 mm/minute to 300 mm/minute. This speed is determined with consideration for the concentration of the process solution, but the stain resistant coating 13 will become too thin and the desired performance cannot be obtained if less than 100 mm/minute, and the stain resistant coating 13 will become too thick and a rinse process will be required to remove coating irregularities if greater than 300 mm/minute.

### Curing process

After the coating process the workpiece is left for 0.5 hour or more in an environment with a temperature of 10 - 60°C and relative humidity of 10 - 90%. Preferably, the temperature is 20 - 50°C and the relative humidity is 20 - 80%. The curing time is preferably 1 - 10 hours.

If the curing temperature is too low, formation of the stain resistant coating 13 will be deficient because the reactivity of the organosilicon compound is low. Conversely, if the curing temperature is too high, cracks result in the stain resistant coating 13 and the appearance of the crystal 1 may be defective.

If the humidity of the curing environment is too low, formation of the stain resistant coating 13 will be deficient because the reactivity of the organosilicon compound is low, in the same way as when the temperature is too low. Likewise, if the humidity is too high, cracks result in the stain resistant coating 13 and the appearance of the crystal 1 may be defective.

Yet further, if the curing time is too short, the reaction of the organosilicon compound will be deficient and formation of the stain resistant coating 13 will be deficient. While a curing time of 0.5 hour or longer is required, a curing time of approximately 24 hours is preferred if the temperature is 25°C and relative humidity is 40%, and a curing time of approximately 2 hours is preferred if the temperature is 60°C and relative humidity is 80%.

Whether a dry method or a wet method as described above is used, the surface of the antireflection coating 12 is preferably pretreated with a plasma process (using argon or oxygen, for example) . Plasma processing the antireflection coating 12 (low index of refraction layer 12D, SiO₂ layer) significantly improves adhesion (bonding) between the antireflection coating 12 and stain resistant coating 13.

The final surface hardness of the antireflection coating 12 after the stain resistant coating 13 is formed is greater than or equal to 24000 N/mm² when measured according to ISO 14577 using a nanoindenter (1.225 mN test load).

The following effects are obtained by the embodiment described above.

A stain resistant coating 13 made of a fluorinated organosilicon compound is formed on top of the antireflection coating 12. In addition to exhibiting a water and oil repellency effect, this stain resistant coating therefore also provides extremely outstanding slipperiness on the surface. Abrasion resistance is also particularly outstanding because if the crystal 2 is subject to external impact, the surface slipperiness of the stain resistant coating 13 can soften the impact. Yet further, the appearance and transparency of the crystal 2 can be maintained for a long time.

By using an alkoxysilane compound or a perfluoroether compound such as described in formulas (1) and (2) above as the fluorinated organosilicon compound used in the stain resistant coating 13, high slipperiness can be imparted to the crystal 2 and as a result outstanding abrasion resistance can be achieved.

By controlling the thickness of the stain resistant coating 13 in the range 0.001 - 0.05 µm, a crystal 1 with sufficient water and oil repellency as well as outstanding abrasion resistance and chemical resistance can be provided.

Because the surface hardness of the crystal 1 is greater than or equal to 24000 N/mm², abrasion resistance sufficient for use in a wristwatch or other portable device can be obtained.

If the stain resistant coating 13 is formed by the specific wet method as described above, not only can a crystal 2 with outstanding abrasion resistance be manufactured, but large equipment such as a vacuum deposition system is not required and the manufacturing cost can be reduced.

Furthermore, if the stain resistant coating 13 is produced by the specific dry method described above, not only can a crystal 2 with outstanding abrasion resistance be manufactured, but the environmental impact is low because solvents are essentially not used. In addition, because changing the conditions of the stain resistant coating 13 formation process is easy, controlling the layer thickness of the stain resistant coating is also simple. The heating efficiency of the fluorinated organosilicon compound is also high as a result of using a fibrous or porous medium.

The invention is not limited to the embodiment described above and can be improved and modified in many ways without departing from the scope of the accompanying claims.

The foregoing embodiments describe examples of applying the invention to a timepiece crystal 1, 2, but the transparent member of the invention is not limited to use as such a crystal. Some mechanical timepieces, for example, use a transparent member as the back cover in a see-through design enabling the inside mechanism of the timepiece to be seen through the transparent member. The invention can also be advantageously used for such a transparent member.

Note that the substrate of the transparent member is sapphire glass because of its high hardness.

### * Specific embodiments and comparative examples

The invention is described in further detail below with reference to specific embodiments and comparative examples. More specifically, samples were manufactured using a common sapphire glass as the substrate of a timepiece crystal, a specific antireflection coating was then formed on the substrate surface, an stain resistant coating was then formed, and various tests were conducted.

Embodiments 1 to 16, comparative examples 1 to 12 demonstrated below do not form part of the present invention.

### * Pretreatment of the substrate

Sapphire glass was immersed for 10 minutes in hot concentrated sulfuric acid at 120°C, then washed thoroughly in pure water, and dried in air for 30 minutes in an oven set to 120°C. The sapphire glass was then placed inside a sputter chamber, and the chamber was reduced to a pressure of 10⁻⁶ Torr while heating to 120°C. Ar gas was then introduced to the chamber and the sapphire glass surface was cleaned by bias sputtering at 0.8 mTorr.

### * Forming the antireflection coating

An antireflection coating of high index of refraction layers and low index of refraction layers (4 - 9 layers) was formed on the surface of the sapphire glass substrate by sputtering under the following conditions using silicon as the target. The specific layer configurations are shown in Tables 1 and 2. The volume percentage of silicon nitride (SiNx) to a depth of 150 nm from the outside surface of the antireflection coating is denoted the SiNx percentage.
High index of refraction layer: silicon nitride (SiNx)
N₂ gas: 10.0 sccm
Ar gas: 10.0 sccm
sputtering power: 2.0 kW
Low index of refraction layer: silicon oxide (SiO₂)
O₂ gas: 10.0 sccm
Ar gas: 10.0 sccm
sputtering power: 1.5 kW
Evaluation items and methods

The samples obtained from the foregoing processes were evaluated as described below and the results are shown in Tables 1 and 2. Sapphire glass was also evaluated as a reference sample.

### (1) Reflectivity (%)

The reflectivity of a standard light incident to the substrate surface at an incidence angle of 90° was obtained, and the result was evaluated based on the product of this reflectivity and the visual sensitivity at the 90° incidence angle at selected wavelengths in the visual spectrum.

### (2) Ray transmittance difference (ΔT%) before and after sand drop test

A sand drop test was conducted as described below. The sample crystal was placed at an angle of 45° to a horizontal surface. The samples were placed with the side of the sample on which the antireflection coating was formed facing up. Sand was then dropped onto the stain resistant coating from a height of 1 m above the horizontal surface. The crystal was then washed, and the degree of scratching was determinedbased on the difference ΔT% between the ray transmittance of the crystal before the test and the ray transmittance of the crystal after the test.

The sand that was used was carborundum manufactured by crushing black silicon carbide ingots and green silicon carbide ingots and then grading the particulate. For this test 800 cm³ of carborundum #24 with an average particle diameter of 600 - 850 pm was used.

### (3) Surface hardness (N/mm²)

The surface hardness of the antireflection coating side of the substrate was tested according to ISO 14577 using a nanoindenter with a 1.225 mN test load.

**Table 1a**

| | Configuration of layers |
|---|---|
| Reference | Substrate (sapphire glass) |
| Embodiment 1 | SiO₂(88nm)/SiNx(91nm)/SiO₂( 12nm) /SiNx(27nm)/substrate |
| Embodiment 2 | SiO₂(89am)/SiNx(85nm)/SiO₂(13nm)/SiNx(28nm)/substrate |
| Embodiment 3 | SiO₂(82nm)/SiNx(79nm)/SiO₂(18nm)/SiNx(17nm)/SiO₂(151nm)/aubstrate |
| Embodiment 4 | SiO₂(88nm)/SiNx(61nm)/SiO₂(20nm)/SiNx(22nm)/SiO₂(159nm)/substrate |
| Embodiment 5 | SiO₂84nm)/SiNx(97nm)/SiO₂(39nm)/SiNx(26nm)/SiO₂(52nm)/SiNx(136nm)/substrate |
| Embodiment 6 | SiO₂(94nm)/SiNx(73nm)/SiO₂(34nm)/SiNx(35nm)/SiO₂(48nm)/SiNx(140nm)/substrate |
| Embodiment 7 | SiO₂(99nm)/SiNx(59nm)/SiO₂(43nm)/SiNx(33nm)/SiO₂(51nm)/SiNx(141nm)/substrate |
| Embodiment 8 | SiO₂(86nm)/SiNx(109nm)/SiO₂(17nm)/SiNx(46nm)/SiO₂(32nm)/SiNx(41nm)/SiO₂(9nm)/substrate |
| Embodiment 9 | SiO₂(89nm)/SiNx(92nm)/SiO₂(14nm)/SiNx(54nm)/SiO₂(32nm)/SiNx(42nm)/SiO₂(10nm)/substrate |
| Embodiment 10 | SiO₂(101nm)/SiNx(65nm)/SiO₂(24nm)/SiNx(56nm)/SiO₂(31nm)/SiNx(47nm)/SiO₂(9nm)/subatrate |
| Embodiment 11 | SiO₂(85nm)/SiNx(98nm)/SiO₂(37nm)/SiNx(26nm)/SiO₂(62nm)/SiNx(40nm)/SiO₂(22nm)/SiNx(33nm)/substrate |
| Embodiment 12 | SiO₂(9 4nm)/SiNx(70nm)/SiO₂(34nm)/SiNx(32nm)/SiO₂(63nm)/SiNx(35nm)/SiO₂(26nm)/SiNx(36nm)/substrate |
| Embodiment 13 | SiO₂(102nm)/SiNx(59nm)/SiO₂(41nm)/SiNx(36nm)/SiO₂(48nm)/SiNx(61nm)/SO₂(11nm)/SiNx(47nm)/substrate |
| Embodiment 14 | SiO₂(81nm)/SiNx(107nm)/SiO₂(26nm)/SiNx(22nm)/SiO₂(53nm)/SiNx(26nm)/SiO₂(29nm)/SiNx(37nm)/SiO₂(9nm)/substrate |
| Embodiment 15 | SiO₂(90nm/SiNx(79nm)SiO₂(23nm)/SiNx(30nm)/SiO₂(54nm)/SiNx(24nm)/SiO₂(37nm)/SiNx(31nm)/SiO₂(9nm)/substrate |
| Embodiment 16 | SiO₂(98nm)/SiNx(68nm)/SiO₂(9nm)/SiNx(158nm)/SiO₂(10nm)/SiNx(19nm)/SiO₂(17nm)/SiNx(26nm)/SiO₂(21nm)/substrate |

**Table 1b**

| | Layers | SiNx (%) | Reflectivity | Transmittance difference (ΔT) | Surface hardness (N/mm2) |
|---|---|---|---|---|---|
| Reference | - | - | 7.00% | 0.01% | 53300 |
| Embodiment 1 | 4 | 41 | 0.40% | 1.50% | 31570 |
| Embodiment 2 | 4 | 41 | 0.40% | 1.50% | 31500 |
| Embodiment 3 | 5 | 45 | 0.40% | 1.40% | 34650 |
| Embodiment 4 | 5 | 41 | 0.40% | 1.50% | 31570 |
| Embodiment 5 | 6 | 44 | 0.25% | 1.40% | 33880 |
| Embodiment 6 | 6 | 37 | 0.25% | 1.70% | 28490 |
| Embodiment 7 | 6 | 34 | 0.25% | 1.80% | 26180 |
| Embodiment 8 | 7 | 43 | 0.30% | 1.40% | 33110 |
| Embodiment 9 | 7 | 41 | 0.30% | 1.50% | 31570 |
| Embodiment 10 | 7 | 33 | 0.40% | 1.90% | 25410 |
| Embodiment 11 | 8 | 43 | 0.25% | 1.40% | 33110 |
| Embodiment 12 | 8 | 37 | 0.25% | 1.70% | 28490 |
| Embodiment 13 | 8 | 32 | 0.25% | 1.90% | 24640 |
| Embodiment 14 | 9 | 46 | 0.25% | 1.30% | 35420 |
| Embodiment 15 | 9 | 40 | 0.25% | 1.50% | 30800 |
| Embodiment 16 | 9 | 35 | 0.35% | 1.80% | 26950 |

**Table 2a**

| | Configuration of layers |
|---|---|
| Reference | Substrate (sapphire glass) |
| Comparison 1 | SiO₂(70nm)/SiNx(91nm)/SiO₂(12nm)/SiNx(27nm)/substrate |
| Comparison 2 | SiO₂(110nm)/SiNx(60nm)/SiO₂(17nm)/SiNx(37nm)/substrate |
| Comparison 3 | SiO₂(70nm)/SiNx(91nm)/SiO₂(18nm)/SiNx(17nm)/SiO₂(151nm)/substrate |
| Comparison 4 | SiO₂(110nm)/SiNx(60nm)/SiO₂(20nm)/SiNx(22nm)/SiO₂(159nm)/substrate |
| Comparison 5 | SiO₂(70nm)/SiNx(91nm)SiO₂(39nm)/SiNx(26nm)/SiO₂(52nm)SiNx(136nm)/substrate |
| Comparison 6 | SiO₂(110nm)/SiNx(60nm)/SiO₂(43nm)/SiNx(33nm)/SiO₂(51nm)/SiNx(141nm)/substrate |
| Comparison 7 | SiO₂(70nm)/SiNx(91nm)/SiO₂(17nm)/SiNx(46nm)/SiO₂(32nm)/SiNx(41nm)/SiO₂(9nm)/substrate |
| Comparison 8 | SiO₂(110nm)/SiNx(60nm)/SiO₂(24nm)/SiNx(56nm)/SiO₂(31nm)/SiNx(47nm)/SiO₂(9nm)/substrate |
| Comparison 9 | SiO₂(70nm)/SiNx(91nm)/SiO₂(37nm)/SiNx(26nm)/SiO₂(62nm)/SiNx(40nm)/SiO₂(22nm)/SiNx(33nm)/substrate |
| Comparison 10 | SiO₂(110nm)/SiNx(60nm)/SiO₂(41nm)/SiNx(36nm)/SiO₂(48nm)/SiNx(61nm)/SiO₂(11nm)/SiNx(47nm)/substrate |
| Comparison 11 | SiO₂(70nm)/SiNx(91nm)/SiO₂(26nm)/SiNx(22nm)/SiO₂(53nm)/SiNx(26nm)/SiO₂(29nm)/SiNx(37nm)/SiO₂(9nm)/substrate |
| Comparison 12 | SiO₂(110nm)/SiNx(60nm)/SiO₂(9nm)/SiNx(158nm)/SiO₂(10nm)/SiNx(19nm)/SiO₂(17nm)/SiNx(26nm)/SiO₂(21nm)/substrate |

**Table 2b**

| | Layers | SiNx (%) | Reflectivity | Transmittance difference (T) | Surface hardness (N/mm2 ) |
|---|---|---|---|---|---|
| Reference | - | - | 7,00% | 0,01% | 53300 |
| Comparison 1 | 4 | 53 | 2,00% | 1,20% | 40800 |
| Comparison 2 | 4 | 27 | 0,43% | 2,30% | 20700 |
| Comparison 3 | 5 | 53 | 2,00% | 1,20% | 40800 |
| Comparison 4 | 5 | 27 | 1,80% | 2,30% | 20790 |
| Comparison 5 | 6 | 53 | 1,00% | 1,20% | 40800 |
| Comparison 6 | 6 | 27 | 0,50% | 2,30% | 20790 |
| Comparison 7 | 7 | 53 | 1,00% | 1,10% | 40800 |
| Comparison 8 | 7 | 27 | 0,50% | 2,30% | 20800 |
| Comparison 9 | 8 | 53 | 0,80% | 1,10% | 40800 |
| Comparison 10 | 8 | 27 | 0,70% | 2,30% | 20780 |
| Comparison 11 | 9 | 53 | 0,50% | 1,10% | 40800 |
| Comparison 12 | 9 | 27 | 1,50% | 2,30% | 20780 |

### * Results

It will be known from the results in Table 1 that regardless of the number of layers in the antireflection coating, by rendering the SiNx percentage in the region to a depth of 150 nm from the outside surface in the range 30 - 50 vol%, the surface hardness can be held to 24000 N/mm² or greater while the transmittance difference (Δ%) before and after sand drop test can simultaneously be held to 2% or less. If the transmittance difference is less than or equal to 2%, scratch resistance is more than sufficient for use as a timepiece crystal. Furthermore, by controlling the SiNx percentage to 40 vol% or greater, the transmittance difference before and after the sand drop test can be further reduced to 1.5% or less. If the transmittance difference is less than or equal to 1.5%, scratch resistance for everyday use is extremely good.

As shown in comparative examples 1, 3, 5, 7, 9, and 11 in Table 2, if the SiNx percentage exceeds 50 vol%, reflectivity exceeds 0.4%, a level that makes practical use difficult. In addition, as shown in comparative examples 2, 4, 6, 8, 10, and 12, if the SiNx percentage is less than 30 vol%, surface hardness is extremely low and the transmittance difference also rises. In other words, scratch resistance is poor.

According to the present invention, a stain resistant coating was additionally formed on the surface of the antireflection coating in embodiments 1, 3, 5, 8, 11, and 14, and the same tests were conducted.

### * Forming the stain resistant coating

A fluorinated organosilicon compound (KY130 (3) , Shin-Etsu Chemical) was diluted with a fluorochemical solvent (FR Thinner, Shin-Etsu Chemical) to 3 wt% solid, and 1.0 g of the diluted solution was placed in a container (a cylindrical copper container, 16 mm inside diameter x 6 mm inside height, open at the top) that was previously filled with steel wool (#0, 0.025 mm fiber diameter, manufactured by Nihon Steel Wool Co. , Ltd.) and then dried for 1 hour at 120°C. This copper container was then placed with the sapphire glass on which the antireflection coating was formed in the vacuum deposition chamber, the chamber was adjusted to a pressure of 0.01 Pa, and the fluorinated organosilicon compound was vaporized from the copper container and deposited on the surface of the sapphire glass at a 0.6 Å/s film formation rate (deposition rate) . The heat source was a molybdenum resistance heating boat.

### * Evaluation of crystal characteristics

The characteristics of the sample crystals manufactured as described above were evaluated. The results are shown in Table 3.

**Table 3**

| | Layers | SiNx (%) | Reflectivity | Transmittance difference (ΔT) | Surface hardness (N/mm2) |
|---|---|---|---|---|---|
| Comparison 17 | 4 | 41 | 0.40% | 1.45% | 31570 |
| Comparison 18 | 5 | 45 | 0.40% | 1.35% | 34650 |
| Comparison 19 | 6 | 44 | 0.25% | 1.35% | 33880 |
| Comparison 20 | 7 | 43 | 0.30% | 1.35% | 33110 |
| Comparison 21 | 8 | 43 | 0.25% | 1.35% | 33110 |
| Comparison 22 | 9 | 46 | 0.25% | 1.25% | 35420 |

### * Results

As shown in Table 3, each of the crystals in embodiments 17 to 22 hada stain resistant coating, and like the crystals (embodiments 1, 3, 5, 8, 11, 14) on which the stain resistant coating was formed, the antireflection effect and abrasion resistance are outstanding. In other words, even if the stain resistant coating is formed, the effect of the SiNx percentage is strongly reflected.

## Claims

1. A timepiece comprising:
a transparent member comprising a transparent substrate and an antireflection coating comprising at least one layer made of silicon nitride and at least one layer made of silicon oxide alternately laminated on at least a part of a surface of the substrate,
wherein the transparent member is a sapphire glass cover member;
and the antireflection coating is formed on at least a part on the outside side from among a group including parts on the inside side and parts on the outside side of the cover member, anc with the transparent member disposed to a case that houses a timepiece movement,
**characterised in that**
the content of silicon nitride in the region to a depth of 150 nm from the outside surface of the antireflection coating is 34 - 50 vol %, and the transparent member further comprises a stain resistant coating made of a fluorinated organosilicon compound formed on the antireflection coating.

2. The transparent member described in claim 1, wherein:
the content of silicon nitride in the region to a depth of 150 nm from the outside surface of the antireflection coating is 40 - 50 vol%.

3. The transparent member described in any one of preceding claims 1-2, wherein:
the surface hardness of the transparent member is greater than or equal to 24000 N/mm² when measured according to ISO 14577 using a nanoindenter and a 1.225 mN test load.

4. The transparent member described in claim 3, wherein:
the surface hardness of the transparent member is greater than or equal to 30000 N/mm².

5. The transparent member described in claim 1-4, wherein:
the fluorinated organosilicon compound is an alkoxysilane compound.

6. The transparent member described in any one of preceding claims, wherein:
the fluorinated organosilicon compound is a perfluoroether compound described in at least one of formula (1) and formula (2), 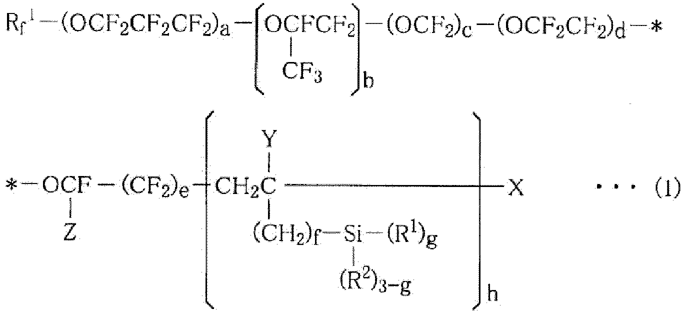 where
R_{f}¹ denotes a perflouroalkyl group;
X denotes boron, iodine, or hydrogen;
Y denotes hydrogen or a lower alkyl group;
Z denotes fluorine or a trifluoromethyl group;
R¹ denotes a hydrolyzable group;
R² denotes hydrogen or an inert monovalent hydrocarbon group;
a, b, c, d, and e are 0 or an integer greater than or equal to 1, a+b+c+d+e is at least greater than or equal to 1, and the order of the repeating units denoted by a, b, c, d, and e is not limited to the order shown in the formula;
f is 0, 1, or 2;
g is 1, 2, or 3; and
h is an integer of 1 or more; or 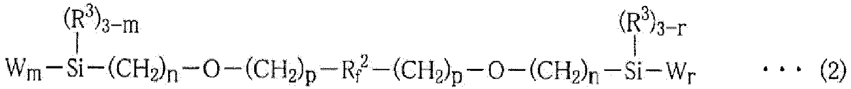
where
R_{f}² denotes a bivalent group that has a straight chain perfluoropolyalkylenether structure with no branches and includes a [-(CₖF₂ₖ)O-] unit where the k in [-(CₖF₂ₖ)O-] is an integer of 1 - 6;
R³ is a monovalent hydrocarbon group with 1 - 8 carbon atoms;
W denotes a hydrolyzable group or a halogen atom;
p is 0, 1, or 2;
n is an integer of 1 - 5; and
m and r are 2 or 3.

7. The transparent member described in any one of preceding claims, wherein:
the thickness of the stain resistant coating is 0.001 - 0.05 µm.

8. A method of manufacturing the transparent member described in any one of preceding claims, comprising:
a sputtering step of forming the high index of refraction layer and low index of refraction layer rendering the antireflection coating by sputtering.

9. The method of manufacturing a transparent member described in claim 8, further comprising:
a heating step whereby sputtering is done while heating the substrate to 100°C or higher.

10. The method of manufacturing a transparent member described in any one of preceding claims 8-9, further comprising:
a reverse sputtering step of bias sputtering the substrate before forming the antireflection coating by sputtering.

## Patentansprüche

1. Uhr, umfassend:
ein transparentes Element, umfassend ein transparentes Substrat und eine Antireflexionsbeschichtung, umfassend mindestens eine aus Siliciumnitrid hergestellte Schicht und mindestens eine aus Siliciumoxid hergestellte Schicht, die abwechselnd auf mindestens einem Teil einer Oberfläche des Substrats laminiert sind,
wobei das transparente Element ein
Saphirglasabdeckelement ist
und die Antireflexionsbeschichtung auf mindestens einem Teil der Außenseite von einer Gruppe, die Teile an der Innenseite und Teile an der Außenseite des Abdeckelements einschließt, gebildet ist und wobei das transparente Element an einem Gehäuse angeordnet ist, in dem sich ein Uhrwerk befindet,
**dadurch gekennzeichnet, dass**
der Gehalt an Siliciumnitrid im Bereich bis zu einer Tiefe von 150 nm, ausgehend von der Außenoberfläche der Antireflexionsbeschichtung, 34-50 Vol.-% beträgt und das transparente Element ferner eine auf der Antireflexionsbeschichtung gebildete schmutzabweisende Beschichtung, die aus einer fluorierten Organosiliciumverbindung hergestellt ist, umfasst.

2. Transparentes Element wie in Anspruch 1 beschrieben, wobei
der Gehalt an Siliciumnitrid im Bereich bis zu einer Tiefe von 150 nm, ausgehend von der Außenseite der Antireflexionsbeschichtung, 40-50 Vol.-% beträgt.

3. Transparentes Element wie in irgendeinem der vorhergehenden Ansprüche 1-2 beschrieben, wobei
die Oberflächenhärte des transparenten Elements größer als oder gleich 24.000 N/mm², gemessen gemäß ISO 14577 unter Verwendung eines Nanoindenters und einer 1,225 mN-Prüflast, ist.

4. Transparentes Element wie in Anspruch 3 beschrieben, wobei
die Oberflächenhärte des transparenten Elements größer oder gleich 30.000 N/mm² ist.

5. Transparentes Element wie in den Ansprüchen 1-4 beschrieben, wobei
die fluorierte Organosiliciumverbindung eine Alkoxysilanverbindung ist.

6. Transparentes Element wie in irgendeinem der vorhergehenden Ansprüche beschrieben, wobei
die fluorierte Organosiliciumverbindung eine Perfluoretherverbindung ist, die in mindestens einer von Formel (1) und Formel (2) beschrieben ist, 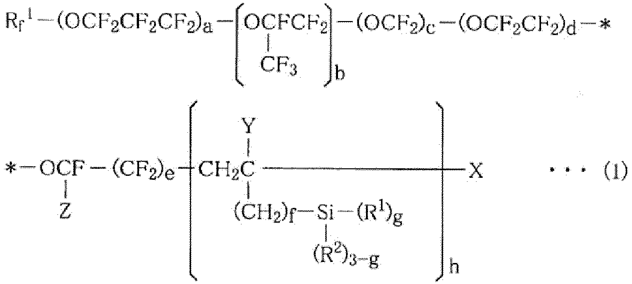 worin
R_{f}¹ eine Perfluoralkylgruppe bezeichnet,
X Bor, Iod oder Wasserstoff bezeichnet,
Y Wasserstoff oder eine Niederalkylgruppe bezeichnet,
Z Fluor oder eine Trifluormethylgruppe bezeichnet,
R¹ eine hydrolysierbare Gruppe bezeichnet,
R² Wasserstoff oder eine inerte einwertige Kohlenwasserstoffgruppe bezeichnet,
a, b, c, d und e 0 oder eine ganze Zahl von größer als oder gleich 1 sind, a+b+c+d+e mindestens größer als oder gleich 1 ist und die Reihenfolge der durch a, b, c, d und e bezeichneten Wiederholungseinheiten nicht auf die in der Formel dargestellte Reihenfolge beschränkt ist,
f 0, 1 oder 2 ist,
g 1, 2 oder 3 ist und
h eine ganze Zahl von 1 oder größer ist, oder 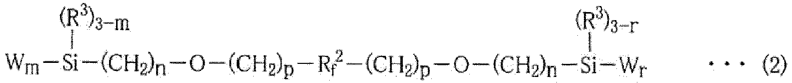
worin
R_{f}² eine zweiwertige Gruppe bezeichnet, die eine geradkettige Perfluorpolyalkylenetherstruktur ohne Verzweigungen aufweist und eine 1-(CₖF₂ₖ)O-]-Einheit einschließt, wobei k in [-(CₖF₂ₖ)O-] eine ganze Zahl von 1-6 ist,
R³ eine einwertige Kohlenwasserstoffgruppe mit 1-8 Kohlenstoffatomen ist,
W eine hydrolysierbare Gruppe oder ein Halogenatom bezeichnet,
p 0, 1 oder 2 ist,
n eine ganze Zahl von 1-5 ist und
m und r 2 oder 3 sind.

7. Transparentes Element wie in irgendeinem der vorhergehenden Ansprüche beschrieben, wobei
die Dicke der schmutzabweisenden Beschichtung 0,001-0,05 µm beträgt.

8. Verfahren zur Herstellung des in irgendeinem der vorhergehenden Ansprüche beschriebenen transparenten Elements, umfassend:
einen Sputterschritt zur Bildung einer Schicht mit hohem Brechungsindex und einer Schicht mit niedrigem Brechungsindex, welche die Antireflexionsbeschichtung ergeben, durch Sputtern.

9. Verfahren zur Herstellung eines transparenten Elements wie in Anspruch 8 beschrieben, ferner umfassend:
einen Erwärmungsschritt, wodurch das Sputtern während des Erwärmens des Substrats auf 100°C oder höher durchgeführt wird.

10. Verfahren zur Herstellung eines transparenten Elements wie in irgendeinem der vorhergehenden Ansprüche 8-9 beschrieben, ferner umfassend:
einen Umkehrsputterschritt zum Bias-Sputtern des Substrats vor der Bildung der Antireflexionsbeschichtung durch Sputtern.

## Revendications

1. Pièce d'horlogerie comprenant :
un élément transparent comprenant un substrat transparent et un revêtement antireflet comprenant au moins une couche constituée de nitrure de silicium et au moins une couche constituée d'oxyde de silicium stratifiées alternativement sur au moins une partie d'une surface du substrat,
dans laquelle l'élément transparent est un élément de couverture en verre de saphir ;
et le revêtement antireflet est formé sur au moins une partie sur le côté extérieur parmi un groupe incluant des parties sur le côté intérieur et des parties sur le côté extérieur de l'élément de couverture, et avec l'élément transparent disposé dans un boîtier qui loge un mouvement de pièce d'horlogerie,
**caractérisée en ce que**
la teneur en nitrure de silicium dans la zone à une profondeur de 150 nm à partir de la surface extérieure du revêtement antireflet va de 34 à 50 % en volume, et l'élément transparent comprend en outre un revêtement résistant aux taches constitué d'un composé d'organosilicium fluoré formé sur le revêtement antireflet.

2. Élément transparent décrit selon la revendication 1, dans lequel :
la teneur en nitrure de silicium dans la zone à une profondeur de 150 nm à partir de la surface extérieure du revêtement antireflet va de 40 à 50 % en volume.

3. Élément transparent décrit selon l'une quelconque des revendications précédentes 1-2, dans lequel :
la dureté de surface de l'élément transparent est supérieure ou égale à 24 000 N/mm² lorsqu'elle est mesurée conformément à la norme ISO 14577 utilisant un nanoindenteur et une charge d'essai de 1,225 mN.

4. Élément transparent décrit selon la revendication 3, dans lequel :
la dureté de surface de l'élément transparent est supérieure ou égale à 30 000 N/mm².

5. Élément transparent décrit selon les revendications 1-4, dans lequel :
le composé d'organosilicium fluoré est un composé d'alcoxysilane.

6. Élément transparent décrit selon l'une quelconque des revendications précédentes, dans lequel :
le composé d'organosilicium fluoré est un composé de perfluoroéther décrit dans au moins l'une parmi les formule (1) et formule (2), 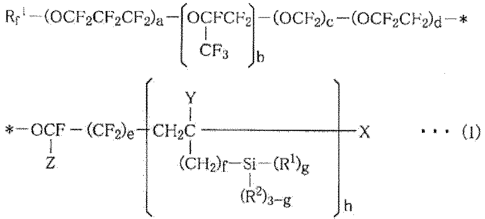 où
R_{f}¹ représente un groupe perfluoroalkyle ;
X représente bore, iode ou hydrogène ;
Y représente hydrogène ou un groupe alkyle inférieur ;
Z représente fluor ou un groupe trifluorométhyle ;
R¹ représente un groupe hydrolysable ;
R² représente hydrogène ou un groupe hydrocarboné monovalent inerte ;
a, b, c, d et e valent 0 ou représentent un nombre entier supérieur ou égal à 1, a + b + c + d + e est au moins supérieur ou égal à 1, et l'ordre des unités répétitives représentées par a, b, c, d et e n'est pas limitée à l'ordre montré dans la formule ;
f vaut 0, 1 ou 2 ;
g vaut 1, 2 ou 3 ; et
h est un nombre entier supérieur ou égal à 1 ; ou 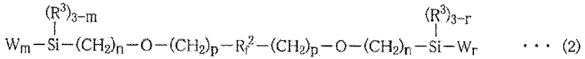
où
R_{f}² représente un groupe bivalent qui présente une structure perfluoropolyalkylènéther à chaîne linéaire sans ramifications et inclut une unité [-(CₖF₂ₖ)O-] où le k dans [-(CₖF₂ₖ)O-] est un nombre entier allant de 1 à 6 ;
R³ représente un groupe hydrocarboné monovalent avec 1 à 8 atomes de carbone ;
W représente un groupe hydrolysable ou un atome d'halogène ;
p vaut 0, 1 ou 2 ;
n est un nombre entier de 1 à 5 ; et
m et r valent 2 ou 3.

7. Élément transparent décrit selon l'une quelconque des revendications précédentes, dans lequel :
l'épaisseur du revêtement résistant aux taches va de 0,001 à 0,05 µm.

8. Procédé de fabrication de l'élément transparent décrit selon l'une quelconque des revendications précédentes, comprenant :
une étape de pulvérisation consistant à former l'indice élevé de couche de réfraction et l'indice faible de couche de réfraction rendant le revêtement antireflet par pulvérisation.

9. Procédé de fabrication d'un élément transparent décrit selon la revendication 8, comprenant en outre :
une étape de chauffage selon laquelle la pulvérisation est réalisée pendant le chauffage du substrat à une température de 100 °C ou plus.

10. Procédé de fabrication d'un élément transparent décrit selon l'une quelconque des revendications précédentes 8-9, comprenant en outre :
une étape de pulvérisation cathodique inverse consistant à pulvériser de manière polarisée le substrat avant la formation du revêtement antireflet par pulvérisation.
